# EUROPEAN PATENT SPECIFICATION

(11) **EP 1 173 651 B1**
(45) Date of publication and mention of the grant of the patent: **17.12.2003**
(21) Application number: 00906512.9
(22) Date of filing: 29.02.2000
(51) Int. Cl.: E06B 3/56, H02B 1/26

(54) **Thermal window and method of fitment therof**
Thermofenster und Einbauverfahren hierfür
Fenêtre isolante et procédé d'ajustage de celle-ci

(43) Date of publication of application: 23.01.2002
(73) Proprietor: Cockburn Thermal Imaging Limited, Marske-by-the-Sea, Cleveland TS11 7BE (GB)
(72) Inventor: HOLLIDAY, Graham Roy, Marske-by-the-Sea, Cleveland TS11 7BE (GB); HOLLIDAY, Antony James, Marske-by-the-Sea, Cleveland TS11 7BE (GB)
(74) Representative: Wilson, Peter
(86) International application number: GB0000711
(87) International publication number: WO01065046

(56) References cited:
- EP-A2- 0 584 462
- DE-A1- 19 519 817
- DE-C2- 3 723 646
- US-A- 5 491 314
- US-A- 5 793 522

## Description

The invention relates to a thermal window for an enclosed or partially enclosed electronic control system of an engineering apparatus to provide for diagnostic inspection of electronic components therein, in particular to a thermal window adapted for after market fitment to such apparatus. The invention also relates to a method for the fitment of a thermal window to such apparatus.

In-situ monitoring of the performance and behaviour of engineering equipment, and in particular of control electronics, is generally desirable to maintain optimise the performance, to diagnose potential problems at an earlier stage, and thus to reduce or avoid major system problems and breakdowns. It is particularly desirable if diagnostic procedures can be carried out in-situ whilst the apparatus is functioning, to avoid expensive periods of down time.

The monitoring of thermal behaviour of electronic components and systems is known as an effective diagnostic tool for the evaluation of performance and the early identification of potential problems. Producing and analysing thermal images of such systems by means of suitable thermal imaging equipment can be a valuable aid in this regard. However, problems arise where the electronic components or systems are wholly or partially enclosed within the overall apparatus, for example behind a control panel and/or within a control box, and as a result not readily accessible and/or visible for such analysis.

To carry out an evaluation of such apparatus it is necessary first to shut down the apparatus. then to open the enclosure to the control electronics, also to trip any safety device which is likely to be in place to prevent operation of the apparatus in such a state, and subsequently to restart the apparatus to perform the analysis. This is likely to lead to long periods of down time, may have safety implications since the apparatus is being operated in a fundamentally unsafe state, and may in relation to certain apparatus and processes be completely impossible.

In such circumstances, the fitment of thermally transparent windows within the walls of the control panel or other enclosure has been proposed to enable the thermal monitoring of electronic components and systems within. Such windows may be provided at the time of manufacture of the apparatus. Additionally, should it become desirable subsequently to effect after market fitment of such windows in existing apparatus in-situ, it has been suggested, for example in US5793522A, that it would be possible to create a suitable aperture in the control panel or enclosure wall, and to mount a thermally transparent window over the apparatus, the window being held in place by a mounting frame which is mechanically fixed thereto by screws or the like. Whilst such a mechanically mounted window might lend itself to fitment to the apparatus both during manufacture or as an after market modification, its fitment as the latter is likely to be a cumbersome process involving periods of apparatus down time.

The present invention is directed towards a thermal window which is adapted to facilitate its ready fitment over an aperture in an engineering apparatus, to facilitate thermal monitoring of components and systems therein, and in particular to facilitate its rapid fitment to an existing apparatus in-situ as an after market modification.

Thus, in accordance with a first aspect of the invention, a thermal window comprises a window frame having a first forward face provided with a recess to receive a window member, a thermally transparent window member engageable within the recess such that a first face lies generally flush with the first face of the frame at least at an edge portion thereof, and a self-adhesive frame mount having a pair of opposing adhesive surfaces and so configured that a first adhesive surface is engageable over the first face of the frame and the edge portion of the window.

With the self-adhesive frame mount so fitted, its second adhesive surface presents a forward face by which the window assembly can engage upon the apparatus to be observed around a suitable aperture so as to engage the frame (and consequently window) in position over the aperture on the casing of the electronic control system, eliminating the need for mechanical fixings. By simplifying the fixing system in this manner, the invention facilitates the ready and rapid fitment of a window to an apparatus in-situ, minimising the need for expensive down time.

With a window of suitable thermal transparency fitted in this manner, a thermal imaging analysis of components and systems within the apparatus is facilitated by use of a suitable thermal imaging means in a manner which will be familiar to the skilled person.

The invention does not exclude the possibility that mechanical fixing might still offer some advantages, and that it might be preferable to maximise the long-term integrity of the mounting by providing additional mechanical engagement means. To facilitate such fixing the window for example the frame, may be provided with means to receive such mechanical engagement means, e.g. in the form of screw/butt holes. However, the self-adhesive mount is sufficient for fitment of the window in accordance with the invention, and the provision of such additional engagement means could be postponed until a subsequent routine maintenance programme during which the apparatus was routinely out of service to minimise unnecessary down time.

In use, the window member serves to provide a physical barrier between the electronic control components and systems and the external user. It will be understood that there are a number of reasons why this might be desirable, including physical protection of the components and in relation to user safety. For many applications, it will be desirable for the window to co-operate with any casing or control panel to create a closed controlled environment for the components (e.g. to prevent ingress of dust, moisture, or the like). In those circumstances, it will be preferable for the window member to be a contiguous whole, and for the self-adhesive frame mount to comprise a self-adhesive frame gasket serving in use, with the window engaged in position on an apparatus to be observed, to effect a gas tight seal between the window and apparatus.

In accordance with this further arrangement, the self-adhesive frame gasket thus serves both as a means to engage the window assembly in position over an aperture on an apparatus to be observed, and as the means to effect a gas tight seal therebetween. By contrast, in similar prior art systems, these two functions have hitherto been provided by separate apparatus in the form of a conventional gasket such as an O-ring and a mechanical fixing such as a screw or bolt or the like. In accordance with this preferred embodiment, the invention therefore offers even greater simplicity of fixing in circumstances where an environmentally sealed unit is desirable.

It will be understood that the purpose of the window member is to afford a degree of protection to the electronic component or systems whilst enabling observation thereof by suitable thermal imaging means. Accordingly, a degree of effective thermal transparency is a necessary requirement of the window member. In many circumstances, particularly where an environmentally sealed unit is desirable, this will most readily be achievable by use of a window member comprising an integral unit fabricated of material exhibiting reasonable infra-red transparency. Nevertheless, the invention is not so restricted, and it might be envisaged, particularly in circumstances where a high degree of environmental protection was not required, that the window member could constitute a mesh-like element, achieving the required degree of effective transparency by virtue of the apertures within the mesh.

The engagement surface between the window and the recessed portion of the frame is preferably also provided with an adhesive member, which again preferably constitutes a gas-tight seal. Whilst this may simply be in the form of glue, there is preferably provided a self-adhesive window gasket having a pair of opposing adhesive surfaces, a first to engage the recessed portion of the frame, and a second to make corresponding engagement upon the window. The window gasket is preferably of similar material to the frame gasket.

Suitable materials for the frame gasket and/or window gasket include adhesive nitrile-based materials.

To optimise performance, the window member may be fabricated from material exhibiting inherent high thermal transparency at the infra-red frequencies under investigation. Suitable materials will suggest themselves to those skilled in the art, and will include specialist glasses and single crystal materials.

Since these materials are relatively expensive, the window preferably further comprises a protective cover mounted on a second rearward face of the window frame and adapted to be moved from a first position in which it covers and protects the window member to a second position in which the window member is exposed. The cover can thus be made of cheap and robust transparent material such as plexi-glass, and then moved out of the way when the thermal imaging means is being operated.

The invention also comprises the window as above described fitted in place on an electronic control system of an engineering apparatus over an aperture in a casing at least partially enclosing such control system such that the second adhesive surface of the self-adhesive frame member effects engagement of the window over an aperture in the casing to facilitate thermal imaging analysis of components and systems therein, and preferably such that the self-adhesive frame member serves as a self-adhesive frame gasket in that the second adhesive surface serves also to effect a gas-tight seal between the window and the casing.

The invention also comprises a method of fitment of a thermal window to an aperture in a casing of an electronic control system for an engineering apparatus comprising the steps of engaging a thermally transparent window member within a recess in a window frame member such that a first forward face of the window frame and a first forward face of the window member at at least an edge portion thereof lie generally flush; fixing a first adhesive surface of a self-adhesive frame mount, having a pair of opposing adhesive surfaces over the first face of the frame and said edge portion of the window; fixing the resultant window and frame assembly in position over an aperture provided on the casing of a system to be observed such that a second surface of the self-adhesive frame mount holds the assembly in position thereon. In particular, a frame mount is provided so configured and with sufficient structural integrity that it will comprise a self-adhesive frame gasket which serves in use to fix the resultant window and frame assembly in position over the aperture so as also to effect a gas tight seal between the window and frame assembly and the casing.

Again, in accordance with the method, the rapid after market fitment of an observation window is facilitated, whether over an existing aperture or over an aperture specifically prepared for the purpose at the time before fitment of the window. Further preferred features of the method will be understood by a direct analogy with the preferred features of the window outlined above.

The invention will now be described by way of example only with particular reference to the accompanying drawings in which:
Figure 1 is a cross sectional view of a window in accordance with the invention mounted in position on the front of a control panel of an engineering apparatus;
Figure 2 is a plan view of the window of Figure 1 prior to mounting.

Referring to the figures, the interior of an electronic control system for engineering apparatus (1) can be seen bounded by a control panel front (3) describing an aperture (4).

Fitted in position over the aperture is a thermal window in accordance with the invention to allow thermal examination from suitable externally placed thermal imaging means (not shown). The window comprises a window member (6) fabricated from glass, single crystal or other suitable material exhibiting high transparency to infra-red wavelengths, mounted upon an aluminium frame (8), and held in place thereon by a double-sided self-adhesive nitrile gasket (7), engaging between a window gasket face (10) on the frame (8) and a rearward face towards the edge of the window member (6).

The window is mounted in position on the control panel front (3) by means of a further double-sided self-adhesive nitrile gasket (9). The gasket (9) effects a seal and also serves to engage the window in position on the control panel front (3).

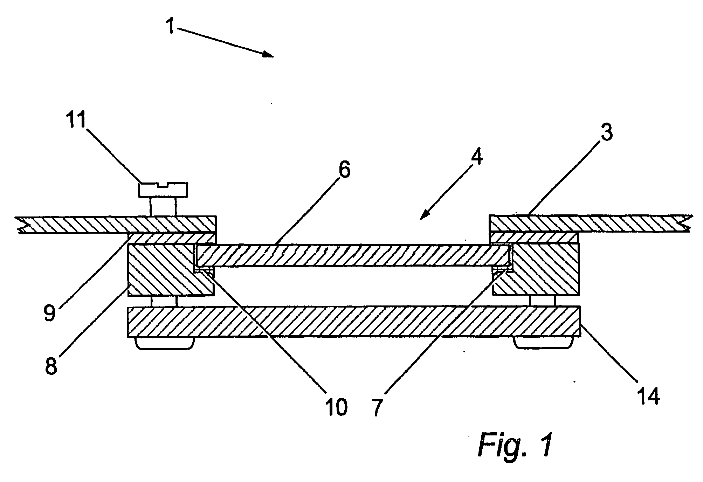

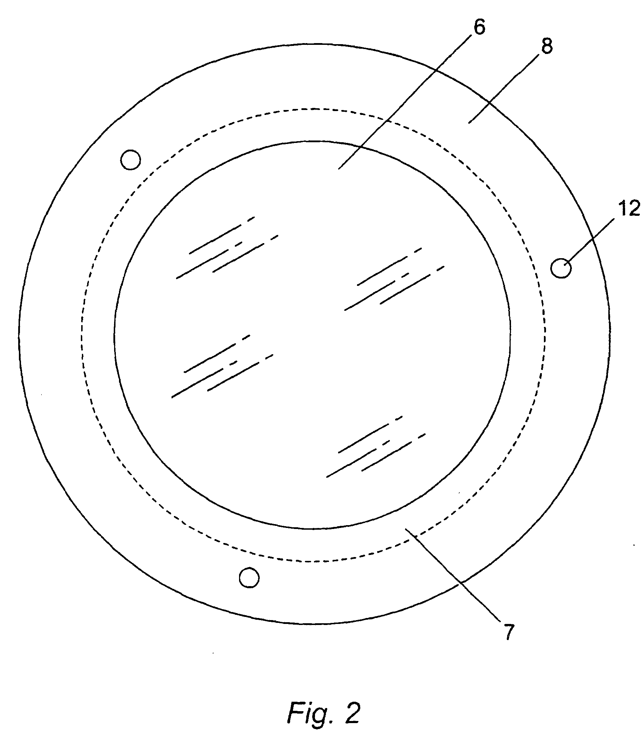

In this embodiment, for increased integrity of mounting, the window is further engaged in position on the control panel front (3) by means of screw fixings (11) which pass through holes (12) provided in the aluminium frame (8). While such screw fixings are to be preferred to safeguard integrity of the seal over time, they are not necessary to the fixing of the apparatus of Figure 2 into position on the apparatus as shown in Figure 1.

A plexi glass cover (14) is provided and is shown in a closed position to protect the window member (6) when the window is not in use. To allow the window to be used and the interior of the apparatus to be viewed by suitable thermal imaging equipment, the cover (14) is mounted to be pivoted around an axis lying generally perpendicular to the plane of the window so as to be rotated out of the way. The cover is provided with a key locking means (not shown) which enables access and use of the window itself to be limited to specific, key-holding personnel.

## Claims

1. A casing for an electronic control system for an engineering apparatus, the casing provided with at least one aperture therein having a thermal window engaged thereupon, the thermal window comprising a window frame (8) having a first forward face provided with a recess to receive a window member (6), and thermally transparent window member (6) engaged within the recess such that a first face lies generally flush with the first face of the frame (8) at least at the edge portion thereof, **characterised in that** it further comprises a self-adhesive frame mount (9) having a pair of opposing adhesive surfaces and so configured that a first adhesive surface is engaged over the first face of the frame and the edge portion of the window, and a second adhesive surface is in position over the aperture to effect engagement of the window thereon.

2. A thermal window according to Claim 1 wherein the frame mount (9) comprises a self-adhesive frame gasket serving in use to effect a gas-tight seal between the window and an apparatus to be observed around a suitable aperture (4) and frame (3) on the casing thereof.

3. A thermal window according to any preceding claim wherein the frame gasket is fabricated from adhesive nitrile-based materials.

4. A thermal window according to any preceding claim wherein an engagement surface between the window and the recess portion of the frame is provided with an adhesive gas-tight seal (7).

5. A thermal window according to Claim 4 wherein the adhesive gas-tight seal (7) comprises a self-adhesive window gasket having a pair of opposing adhesive surfaces.

6. A thermal window according to Claim 5 wherein the window gasket is of similar material to the frame gasket.

7. A thermal window according to claim 5 or 6 wherein the frame window gasket are fabricated from adhesive nitrile-based materials.

8. A thermal window according to any preceding claim wherein the window member (6) is fabricated from a specialist glass material selected to exhibit high transparency to infra-red frequencies.

9. A thermal window according to any one of Claims 1 to 6 wherein the window member (6) is fabricated from a single crystal material selected to exhibit high transparency to infa-red frequencies.

10. A thermal window according to any preceding claim wherein the window further comprises a protective cover (14) mounted on a second rearward base of the window frame (8) and adapted to be moved from a first position in which it covers and protects the window member (6) to a second position in which the member is exposed.

11. A thermal window according to Claim 9 wherein the protective cover is mounted to be pivoted around an axis lying generally perpendicular to the plane of the window so as to be rotated between the first and the second position.

12. A thermal window according to Claims 9 or 10 wherein the protective cover is provided with key locking means to lock the window in position in at least the first position.

13. A thermal window in accordance with any preceding claim further provided with means to receive additional mechanical mounting (11) when in position on an apparatus.

14. A thermal window according to Claim 13 wherein the said means to receive additional mechanical mountings, comprise screw/bolt holes provided in the window frame.

15. An electronic control system for an engineering apparatus, said control system at least partially enclosed within a casing in accordance with any preceding claim.

16. A method of fitment of a thermal window to an aperture (4) in a casing (3) of an electronic control system for an engineering apparatus comprising the steps of engaging a thermally transparent window member (6) within a recess in a window frame member (8) such that a first forward face of the window frame and a first forward face of the window member at at least an edge portion thereof lie generally flush; fixing a first adhesive surface of a self-adhesive frame mount (9) having a pair of opposing adhesive surfaces over the first face of the frame and said edge portion of the window; fixing the resultant window and frame assembly in position over an aperture (4) provided on the casing (3) of a system to be observed such that a second surface of the self-adhesive frame mount (9) holds the assembly in position thereon.

17. The method of claim 16 comprising a method of fitment of a thermal window to an aperture (4) in a casing (3) of an electronic control system for an engineering apparatus as an after market fitment to an existing apparatus in situ.

## Patentansprüche

1. Ein Gehäuse für ein System zur elektronischen Steuerung einer technischen Vorrichtung, wobei das Gehäuse mit wenigstens einer Öffnung ausgestattet ist, an der ein Thermofenster befestigt ist, wobei das Thermofenster einen Fensterrahmen (8), der eine erste mit einer Aussparung versehene Vorderfläche zum Aufnehmen eines Fensterelementes (6) aufweist, und ein thermisch transparentes Fensterelement (6) umfasst, das in der Aussparung derart befestigt ist, dass eine erste Fläche im Allgemeinen bündig mit der ersten Fläche des Rahmens (8) zumindest in deren Kantenbereich anliegt, **dadurch gekennzeichnet, dass** es weiterhin einen selbstklebenden Trägerrahmen (9) umfasst, der ein Paar von gegenüberliegenden, klebenden Oberflächen aufweist und so gebildet ist, dass eine erste klebende Oberfläche über der ersten Fläche des Rahmens und dem Kantenbereich des Fensters befestigt ist und dass eine zweite klebende Oberfläche sich über der Öffnung befindet, um die Befestigung des Fensters daran zu bewirken.

2. Thermofenster nach Anspruch 1, wobei der Trägerrahmen (9) einen selbstklebenden Dichtungsrahmen umfasst, der in der Verwendung dazu dient, eine gasdichte Abdichtung zwischen dem Fenster und einen zu beobachtenden Apparat um eine geeignete Öffnung (4) und einem Rahmen (3) an dem Gehäuse zu bewirken.

3. Thermofenster nach einem vorangehenden Anspruch, wobei der Dichtungsrahmen aus klebenden, auf Nitril basierenden Materialien hergestellt wird.

4. Thermofenster nach einem vorangehenden Anspruch, wobei eine Befestigungsoberfläche zwischen dem Fenster und dem Aussparungsbereich des Rahmens mit einer klebenden, gasdichten Abichtung (7) ausgestattet wird.

5. Thermofenster nach Anspruch 4, wobei die klebende, gasdichte Abdichtung (7) eine klebende Fensterdichtung umfasst, die ein Paar von gegenüberliegenden klebenden Oberflächen aufweist.

6. Thermofenster nach Anspruch 5, wobei die Fensterdichtung von ähnlichem Material ist wie die Rahmendichtung.

7. Thermofenster nach Anspruch 5 oder 6, wobei die Fensterrahmendichtung aus klebenden, auf Nitril basierenden Materialien hergestellt wird.

8. Thermofenster nach einem vorangehenden Anspruch, wobei das Fensterelement (6) aus einem speziellen Glasmaterial hergestellt ist, das ausgewählt ist, um eine hohe Transparenz gegenüber infraroten Frequenzen aufzuweisen.

9. Thermofenster nach einem der Ansprüche 1 bis 6, wobei das Fensterelement (6) aus einem einkristallinen Material hergestellt ist, das ausgewählt ist, um eine hohe Transparenz gegenüber infraroten Frequenzen aufzuweisen

10. Ein Thermofenster nach einem vorangehenden Anspruch, wobei das Fenster weiterhin eine Schutzabdeckung (14) aufweist, die auf eine zweite rückwärtige Basis des Fensterrahmens (8) befestigt wird und dazu ausgelegt ist, von einer ersten Position, in der sie das Fensterelement (6) abdeckt und schützt, in eine zweite Position, in der das Element exponiert ist, bewegt zu werden.

11. Thermofenster nach Anspruch 9, wobei die Schutzabdeckung so befestigt wird, um um eine senkrecht zu der Fensterebene liegende Achse gedreht zu werden, um zwischen der ersten und zweiten Position rotiert zu werden.

12. Thermofenster nach den Ansprüchen 9 oder 10, wobei die Schutzabdeckung über ein Verschlussmittel verfügt, um das positionierte Fenster wenigstens in der ersten Position abzuschließen.

13. Thermofenster nach einem vorangehenden Anspruch, das weiterhin mit Mitteln ausgestattet ist, um zusätzliche mechanische Befestigung (11) in Anbringung an eine Vorrichtung zu empfangen.

14. Thermofenster nach Anspruch 13, wobei die Mittel zum Empfangen von zusätzlichen mechanischen Befestigungen Schrauben-/Bolzen Löcher umfassen, die in dem Fensterrahmen bereit gestellt werden.

15. Ein System zur elektronischen Steuerung einer technischen Vorrichtung, wobei das Steuersystem zumindest teilweise in einem Gehäuse nach einem vorangehenden Anspruch eingeschlossen ist.

16. Ein Verfahren zum Montieren eines Thermofensters an eine Öffnung (4) in einem Gehäuse (3) eines Systems zur elektronischen Steuerung einer technischen Vorrichtung, das die Schritte umfasst
Befestigen eines thermisch transparenten Fensterelementes (6) in einer Aussparung eines Rahmen (8) eines Fensterelementes, sodass eine erste Vorderfläche des Fensterrahmes und eine erste Vorderfläche des Fensterelementes zumindest teilweise in deren Kantenbereich bündig anliegen;
Befestigen einer ersten klebenden Oberfläche auf einem selbstklebenden Trägerrahmen (9), der ein erstes Paar von gegenüberliegenden klebenden Oberflächen über der ersten Fläche des Rahmens und den genannten Kantenbereich des Fensters aufweist;
Befestigen der resultierenden Einheit aus Fenster und Rahmen über einer Öffnung (4), die an dem Gehäuse (3) eines zu beobachtenden Systems vorgesehen ist, sodass eine zweite Oberfläche des selbstklebenden Trägerrahmens (9) die Einheit dort positioniert festhält.

17. Verfahren nach Anspruch 16, das ein Verfahren des Montierens eines Thermofensters an eine Öffnung (4) in einem Gehäuse (3) eines Systems zur elektronischen Steuerung einer technischen Vorrichtung als eine Montage an einen existierenden Apparat in Situ nachträglich nach dem Kauf umfasst.

## Revendications

1. Boîtier pour système de commande électrique pour un appareil d'ingénierie, le boîtier étant muni d'au moins une ouverture dans celui-ci ayant une fenêtre thermique engagée sur celui-ci, la fenêtre thermique comprenant un cadre de fenêtre (8) ayant une première face avant munie d'un évidement pour recevoir un élément de fenêtre (6), et un élément de fenêtre thermiquement transparent (6) engagé dans l'évidement afin qu'une première face repose généralement de manière à affleurer avec la première face du cadre (8) au moins une partie d'arête de celui-ci, **caractérisé en ce qu'**il comprend en outre un montage de cadre auto-adhésif (9) ayant une paire de surfaces adhésives opposées et configuré afin qu'une première surface adhésive soit engagée sur la première face du cadre et la partie d'arête de la fenêtre, et qu'une seconde surface adhésive soit en position sur l'ouverture afin d'effectuer l'engagement de la fenêtre sur celle-ci.

2. Fenêtre thermique selon la revendication 1, dans laquelle le montage de cadre (9) comprend un joint d'étanchéité de cadre auto-adhésif servant au cours de l'utilisation à réaliser un joint étanche au gaz entre la fenêtre et un appareil à observer autour d'une ouverture convenable (4) et du cadre (3) sur le boîtier de celle-ci.

3. Fenêtre thermique selon l'une quelconque des revendications précédentes dans laquelle le joint d'étanchéité du cadre est fabriqué à partir de matériaux adhésifs à base de nitrile.

4. Fenêtre thermique selon l'une quelconque des revendications précédentes dans laquelle une surface d'engagement entre la fenêtre et la partie d'évidemment du cadre est munie d'un joint d'étanchéité au gaz adhésif (7) .

5. Fenêtre thermique selon la revendication 4 dans laquelle le joint d'étanchéité adhésif (7) comprend un joint d'étanchéité de fenêtre auto-adhésif ayant une paire de surfaces opposées adhésives.

6. fenêtre thermique selon la revendication 5 dans laquelle le matériau du joint d'étanchéité de la fenêtre est similaire à celui du joint d'étanchéité du cadre.

7. Fenêtre thermique selon l'une des revendications 5 ou 6 dans laquelle le joint d'étanchéité du cadre de fenêtre est fabriqué à partir de matériaux adhésifs à base de nitrile.

8. Fenêtre thermique selon l'une quelconque des revendications précédentes dans laquelle l'élément de fenêtre (6) est fabriqué à partir de matériau de verre spécialisé sélectionné pour présenter une transparence élevée aux fréquences infra-rouges.

9. Fenêtre thermique selon l'une quelconque des revendications précédentes dans laquelle l'élément de fenêtre (6) est fabriqué à partir d'un matériau unique de cristal sélectionné pour montrer une transparence élevée aux fréquences infra-rouges.

10. Fenêtre thermique selon l'une quelconque des revendications précédentes dans laquelle la fenêtre comprend en outre un capot de protection (14) monté sur une seconde base à l'extrémité arrière du cadre de fenêtre (8) et adapté pour être déplacé à partir d'une première position dans laquelle il couvre et protège l'élément de fenêtre (6) à une seconde position dans laquelle l'élément est exposé.

11. Fenêtre thermique selon la revendication 9 dans laquelle le capot de protection est monté pour être pivoté autour d'un axe généralement perpendiculaire au plan de la fenêtre afin d'être pivoté entre la première et la seconde position.

12. Fenêtre thermique selon l'une des revendications 9 ou 10 dans laquelle le capot de protection est muni de moyens de verrouillage à clé pour verrouiller la fenêtre en position au moins dans la première position.

13. Fenêtre thermique selon l'une quelconque des revendications précédentes munie en outre de moyens pour recevoir un montage mécanique supplémentaire (11) lorsqu'elle est en position sur un appareil.

14. Fenêtre thermique selon la revendication 13 dans laquelle lesdits moyens pour recevoir des montages mécaniques supplémentaires, comprennent des trous de vis/boulon prévus dans le cadre de fenêtre.

15. Système de commande électronique pour un appareil d'ingénierie, ledit système de commande étant au moins partiellement enfermé dans un boîtier selon l'une quelconque des revendications précédentes.

16. Procédé d'installation d'une fenêtre thermique sur une ouverture (4) dans un logement (3) d'un système de commande électronique pour un appareil d'ingénierie comprenant.les étapes consistant à engager un élément de fenêtre thermiquement transparente (6) à l'intérieur d'un évidement dans un élément de cadre de fenêtre (8) afin qu'une première face avant du cadre de fenêtre et une première face avant de l'élément de fenêtre au niveau d'au moins une partie d'arête de celui-ci reposent généralement de manière affleurée ; fixer une première surface adhésive d'un montage de cadre (9) auto-adhésif ayant une paire de surfaces adhésives opposées sur la première face du cadre et ladite partie d'arête de la fenêtre ; fixer la fenêtre obtenue et l'assemblage de cadre en position au-dessus d'une ouverture (4) prévue dans le boîtier (3) d'un système à observer de manière à ce qu'une seconde surface de montage de cadre (9) auto-adhésif maintienne l'assemblage en position sur celui-ci.

17. Procédé selon la revendication 16 comprenant un procédé d'installation de fenêtre thermique sur une ouverture (4) dans un boîtier (3) d'un système de commande électronique pour un appareil d'ingénierie en tant qu'installation secondaire pour un appareil existant in situ.
